# EUROPÄISCHE PATENTSCHRIFT

(11) **EP 2 130 295 B1**
(45) Veröffentlichungstag und Bekanntmachung des Hinweises auf die Patenterteilung: **13.11.2013**
(21) Anmeldenummer: 08718115.2
(22) Anmeldetag: 20.03.2008
(51) Int. Cl.: H03D 3/24

(54) **LOCK-IN-VERSTÄRKER UND VERFAHREN ZUM FILTERN EINES MESSSIGNALS MITTELS EINES SOLCHEN VERSTÄRKERS**
LOCK-IN AMPLIFIER AND METHOD FOR FILTERING A MEASUREMENT SIGNAL USING SUCH AN AMPLIFIER
AMPLIFICATEUR SYNCHRONE ET PROCÉDÉ DE FILTRAGE D'UN SIGNAL DE MESURE AU MOYEN D'UN TEL AMPLIFICATEUR

(30) Priorität: 02.04.2007 DE 102007015913
(43) Veröffentlichungstag der Anmeldung: 09.12.2009
(73) Patentinhaber: Siemens Aktiengesellschaft, 80333 München (DE)
(72) Erfinder: KIMMIG, Ludwig, 76275 Ettlingen (DE); KRAUSE, Peter, 76187 Karlsruhe (DE); LUDWIG, Michael, 76149 Karlsruhe (DE)
(86) Internationale Anmeldenummer: PCT/EP2008/053406
(87) Internationale Veröffentlichungsnummer: WO 2008/119680

(56) Entgegenhaltungen:
- EP-A- 0 119 711
- EP-A- 0 955 727
- LAGUESSE M: "Les techniques de démodulation synchrone : principes de base et caractéristiques générales" BULLETIN SCIENTIFIQUE - ASSOCIATION DES INGENIEURS ELECTRICIENSSORTIS DE L'INSTITUT ELECTROTECHNIQUE MONTEFIORE, LIEGE, BE, Bd. 103, Nr. 4, 1. Januar 1990 (1990-01-01), Seiten 3-9, XP009102318 ISSN: 0302-2676
- SONNAILLON MAXIMILIANO ET AL: "A low-cost, high-performance, digital signal processor-based lock-in amplifier capable of measuring multiple frequency sweeps simultaneously" REVIEW OF SCIENTIFIC INSTRUMENTS, AIP, MELVILLE, NY, US, Bd. 76, Nr. 2, 20. Januar 2005 (2005-01-20), Seiten 24703-024703, XP012079200 ISSN: 0034-6748
- GNUDI A ET AL: "Integrated lock-in amplifier for sensor applications" SOLID-STATE CIRCUITS CONFERENCE, 1999. ESSCIRC '99. PROCEEDINGS OF THE 25TH EUROPEAN DUISBURG, GERMANY 21-23 SEPT. 1999, PISCATAWAY, NJ, USA,IEEE, 21. September 1999 (1999-09-21), Seiten 58-61, XP010824210 ISBN: 978-2-86332-246-8

## Beschreibung

Die Erfindung betrifft einen Lock-In-Verstärker nach dem Oberbegriff des Anspruchs 1 bzw. ein Verfahren zum Filtern eines Messsignals mittels eines Lock-In-Verstärkers nach dem Oberbegriff des Anspruchs 3.

Ein derartiger Lock-In-Verstärker bzw. ein derartiges Verfahren sind aus dem praktikumsbegleitenden Skriptum "Signalverarbeitung mit Lock-In-Verstärker" des Instituts für Festkörperphysik der Technischen Universität Berlin, online im Internet: URL: http://sol.physik.tuberlin.de/htm group/teaching/scripte/LockIn 2004.pdf (Stand 23.03.2007),
bekannt. Dabei wird ein moduliertes Messsignal, das Störsignalanteile, insbesondere Rauschen, enthält, in einem phasensensitiven Detektor (Demodulator) mit einem Referenzsignal bei der Modulationsfrequenz multipliziert und so phasensensitiv demoduliert. Anschließend wird das demodulierte Messsignal in einem Integrator (Tiefpassfilter) über eine vorgegebene Integrationsdauer (Filterzeitkonstante) integriert, um den Nutzsignalanteil des Messsignals aus den Störsignalanteilen zu extrahieren.

Da die Amplitude des herausgefilterten Nutzsignalanteils (Inphasenkomponente) von der Phasendifferenz zwischen der Modulationsfrequenz und der Frequenz des Referenzsignals abhängig ist und ein Nachregeln der Phasendifferenz auf Null oft nicht praktikabel ist, wird bei einem Zweiphasen-Lock-In-Verstärker das Messsignal zusätzlich in einem weiteren phasensensitiven Detektor mit dem um 90° phasenverschobenen Referenzsignal bei der Modulationsfrequenz multiplikativ gemis.cht und anschließend in einem weiteren Integrator über eine vorgegebene Integrationsdauer integriert. Aus der so erhaltenen Quadraturkomponente und der Inphasenkomponente kann der Nutzsignalanteil nicht-phasenbehaftet ermittelt werden.

Bei der oben erwähnten Integration des demodulierten Messsignals stellt die Wahl der Integrationsdauer einen Kompromiss zwischen dem Eliminieren möglichst aller Störsignalanteile, also auch derjenigen Störsignalanteile, deren Frequenz nahe bei der Modulationsfrequenz liegt, und einer möglichst schnellen Reaktion des Lock-In-Verstärkers auf Änderungen des Nutzsignalanteils des Messsignals dar.

Der Erfindung liegt daher die Aufgabe zugrunde, die Störsignalanteile in einem möglichst weiten Dynamikbereich zuverlässig herauszufiltern und zugleich die unvermeidliche Beeinflussung des Nutzsignalanteils auf ein Minimum zu reduzieren.

Gemäß der Erfindung wird die Aufgabe durch den in Anspruch 1 definierten Lock-In-Verstärker bzw. das in Anspruch 3 definierte Verfahren gelöst.

Vorteilhafte Weiterbildungen des erfindungsgemäßen Lock-In-Verstärkers bzw. Verfahrens sind den Unteransprüchen zu entnehmen.

Die Erfindung beruht auf der Erkenntnis, dass die durch das Mischen des Messsignals mit dem Referenzsignal erzeugte Inphasenk_omponente sowohl den Nutzsignalanteil als auch die Störsignalanteile enthält, während die durch das Mischen des Messsignals mit dem um 90° phasenverschobenen Referenzsignal erzeugte Quadraturkomponente näherungsweise nur die Störsignalanteile enthält. Mit Hilfe der Quadraturkomponente kann somit das Ausmaß der Störungen quantitativ erfasst und im Weiteren die Integrationsdauer beim Herausfiltern des Nutzsignalanteils in Abhängigkeit von dem Ausmaß der Störungen optimal eingestellt werden.

Die Störsignalstärke bzw. Energie der Störsignalanteile kann in vorteilhafter Weise dadurch ermittelt werden, dass das mit dem um 90° phasenverschobenen Referenzsignal gemischte Messsignal zunächst quadriert und dann über eine feste Integrationsdauer integriert wird.

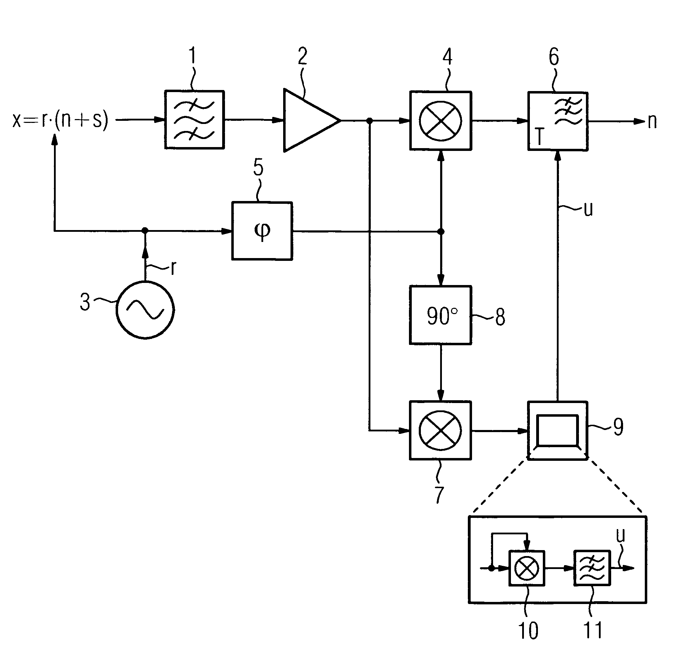

Zur weiteren Erläuterung der Erfindung wird auf die einzige Figur der Zeichnung Bezug genommen, die ein Ausführungsbeispiel des erfindungsgemäßen Lock-In-Verstärkers zeigt.

Der hier gezeigte Lock-In-Verstärker enthält ein Bandpassfilter 1 und einen Verstärker 2 zum Vorfiltern und Verstärken eines Messsignals x. Das aus einem Nutzsignalanteil n und Störsignalanteilen s bestehende Messsignal x ist moduliert, d. h. es ist von sich aus periodisch oder es wird zwangsweise moduliert. Dabei ist unter dem Begriff Messsignal auch eine nichtelektrische Messgröße zu verstehen, die moduliert und anschließend in ein elektrisches Signal umgewandelt wird. Ein Referenzsignalgenerator 3 erzeugt ein Referenzsignal r mit der gleichen Frequenz wie die Modulationsfrequenz des Messsignals x. Dabei kann, wie hier gezeigt, das Referenzsignal r selbst zur Modulation des Messsignals x dienen oder aus dem modulierten Messsignal x abgeleitet werden. Das bandpassgefilterte und verstärkte Messsignal x wird in einem phasensensitiven Detektor 4 mit dem Referenzsignal r multipliziert und so phasensensitiv demoduliert. Dazu kann das Referenzsignal r zuvor eine Phasenschieber 5 durchlaufen, um einen Phasenabgleich zwischen dem Referenzsignal r und dem Messsignal x zu ermöglichen. Anschließend wird das demodulierte Messsignal in einem Integrator 6 über eine vorgegebene Integrationsdauer T integriert, um den Nutzsignalanteil n des Messsignals x aus den Störsignalanteilen s zu extrahieren.

Die Störsignalanteile s können neben Rauschen auch sporadisch vorkommende, beispielsweise durch Erschütterungen hervorgerufene, Störungen enthalten. Um solche Störungen aus dem Messsignal x zu entfernen, ist bei der Integration in dem Integrator 6 eine relativ große Integrationsdauer T erforderlich. Andererseits reagiert aber der Lock-In-Verstärker aber bei großer Integrationsdauer T relativ träge auf Änderungen des Nutzsignalanteils n des Messsignals x.

Daher wird das bandpassgefilterte und verstärkte Messsignal x in einem weiteren phasensensitiven Detektor 7 mit dem zuvor in einem weiteren Phasenschieber 8 um 90° phasenverschobenen Referenzsignal r multipliziert und anschließend in einer Steuereinrichtung 9 mit entsprechenden Mitteln 10 und 11 zuerst quadriert und dann über eine vorgegebene Integrationsdauer integriert. Auf diese Weise wird eine Steuergröße u ermittelt, die ein Maß für die der Störsignalstärke der Störsignalanteile s ist und mit der die Integrationsdauer T des Integrators 6 verändert wird, indem mit zunehmender Störsignalstärke die Integrationsdauer T vergrößert und mit abnehmender Störsignalstärke die Integrationsdauer T verringert wird.

Die Erfindung kann gleichermaßen bei Einphasen- und Zweiphasen-Lock-In-Verstärkern zur Anwendung kommen. Die Signalverarbeitung kann analog oder digital erfolgen, wobei Integrator und Tiefpassfilter bzw. Integrationsdauer und Filterzeitkonstante als Synonyme zu verstehen sind.

Die Filterung des Messsignals x mit dem erfindungsgemäßen Lock-In-Verstärker kann beispielsweise wie folgt vorgenommen werden: Die Modulation des Messsignals x oder die Phasenverschiebung (Phasenschieber 5) des Referenzsignals r werden bei Abwesenheit von sporadischen Störungen in einem Abgleichschritt so eingestellt, dass das mit dem um 90° phasenverschobenen Referenzsignal r multiplizierte Messsignal x (Quadraturkomponente) Null ist. Die Integrationsdauer T des Integrators 6 für die Inphasenkomponente ist auf einen Grundwert von z. B. 1 s festgelegt, bei dem die Anforderungen an das Nutz-/Störsignalverhältnis eingehalten werden. Die Integrationsdauer des weiteren Integrators 11 ist ebenfalls auf einen Grundwert (z. B. 1 s) festgelegt. Die der Störsignalstärke entsprechende Steuergröße u wird auf Eins normiert. Im Weiteren wird der Grundwert der Integrationsdauer T des Integrators 6 mit der Steuergröße u multipliziert, um die Integrationsdauer T des Integrators 6 einzustellen. Steigt der Störsignalpegel auf das Doppelte des Normalwertes, vervierfacht sich aufgrund des Quadrierens in den Mitteln 10 die Integrationsdauer T auf 4 s. Bei als Tiefpass erster Ordnung ausgeführtem Integrator 6 ergibt die Vervierfachung der Integrationsdauer bzw. Filterzeitkonstanten T eine Halbierung des Rauschens, so dass das Nutz-/Störsignalverhältnis erhalten bleibt.

## Patentansprüche

1. Lock-In-Verstärker mit einem phasensensitiven Detektor (4) und einem diesem nachgeordneten Integrator (6), in denen Störsignalanteile (s), die in einem modulierten Messsignal (x) enthalten sind, durch multiplikatives Mischen des Messsignals (x) mit einem Referenzsignal (r) bei der Modulationsfrequenz und durch anschließendes Integrieren über eine vorgegebene Integrationsdauer (T) eliminiert werden, und mit einem weiteren phasensensitiven Detektor (7), in dem das Messsignal (x) mit dem um 90° phasenverschobenen Referenzsignal (r) bei der Modulationsfrequenz multiplikativ gemischt wird, **dadurch gekennzeichnet, dass** dem weiteren phasensensitiven Detektor (7) eine Steuereinrichtung (9) nachgeordnet ist, die aus dem mit dem um 90° phasenverschobenen Referenzsignal (r) gemischten Messsignal (x) eine der Störsignalstärke entsprechende Steuergröße (u) ermittelt und mit der Steuergröße (u) proportional zu dieser die Integrationsdauer (T) des Integrators (6) verändert.

2. Lock-In-Verstärker nach Anspruch 1, **dadurch gekennzeichnet, dass** die Steuereinrichtung (9) Mittel (10, 11) zum Quadrieren und anschließenden Integrieren des mit dem um 90° phasenverschobenen Referenzsignal (r) gemischten Messsignals (x) enthält.

3. Verfahren zum Filtern eines Messsignals (x), bei dem Störsignalanteile (s), die in dem modulierten Messsignal (x) enthalten sind, durch multiplikatives Mischen des Messsignals (x) mit einem Referenzsignal (r) bei der Modulationsfrequenz und durch anschließendes Integrieren über eine vorgegebene Integrationsdauer (T) eliminiert werden und bei dem ferner das Messsignal (x) mit dem um 90° phasenverschobenen Referenzsignal (r) bei der Modulationsfrequenz multiplikativ gemischt wird, **dadurch gekennzeichnet, dass** aus dem mit dem um 90° phasenverschobenen Referenzsignal (r) gemischten Messsignal (x) eine der Störsignalstärke entsprechende Steuergröße (u) ermittelt wird und dass mit der Steuergröße (u) proportional zu dieser die Integrationsdauer (T) verändert wird.

4. Verfahren nach Anspruch 3, **dadurch gekennzeichnet, dass** das mit dem um 90° phasenverschobenen Referenzsignal (r) gemischte Messsignal (x) zur Ermittlung der Steuergröße (u) quadriert und anschließend integriert wird.

## Claims

1. Lock-in amplifier comprising a phase-sensitive detector (4) and an integrator (6) arranged downstream thereof, in which interference signal components (s), which are contained in a modulated measurement signal (x), are eliminated by mixing the measurement signal (x) with a reference signal (r) in a multiplicative fashion for the modulation frequency and are eliminated by subsequent integration over a predetermined integration duration (T) and is mixed with a further phase-sensitive detector (7) in which the measurement signal (x) is mixed in a multiplicative fashion with the reference signal (r) phase shifted by 90 degrees for the modulation frequency, **characterised in that** a control device (9) is arranged downstream of the additional phase-sensitive detector (7), said control device determining a control variable (u) corresponding to the interference signal strength from the measurement signal (x) mixed with the reference signal (r) phase shifted by 90 degrees and changing the integration duration (T) of the integrator (6) using the control variable (u) which is proportional hereto.

2. Lock-in amplifier according to claim 1, **characterised in that** the control device (9) contains means (10, 11) for squaring and subsequently integrating the measurement signal (x) mixed with the reference signal (r) phase shifted by 90 degrees.

3. Method for filtering a measurement signal (x), in which interference signal components (s), which are contained in the modulated measurement signal (x), are eliminated by multiplicative mixing of the measurement signal (x) with a reference signal (r) for the modulation frequency and by subsequent integration over a predetermined integration duration (T) and whereby the measurement signal (x) is also mixed with the reference signal (r) phase shifted by 90 degrees in a multiplicative fashion for the modulation frequency, **characterised in that** a control variable (u) corresponding to the interference signal strength is determined from the measurement signal (x) mixed with the reference signal (r) phase shifted by 90 degrees, and that the control variable (u) is used to change the integration duration (T) proportionally thereto.

4. Method according to claim 3, **characterised in that** the measurement signal (x) mixed with the reference signal (r) phase shifted by 90 degrees is squared to determine the control variable (u) and is then integrated.

## Revendications

1. Amplificateur synchrone ayant un détecteur ( 4 ) de phase et un intégrateur ( 6 ) en aval de celui-ci, dans lesquels des parties ( s ) de signal parasite, qui sont contenues dans un signal ( x ) de mesure modulé, sont éliminées par mélange multiplicatif du signal ( x ) de mesure à un signal ( r ) de référence à la fréquence de modulation et par intégration ensuite sur une durée ( T ) d'intégration prescrite et comprenant un autre détecteur ( 7 ) de phase, dans lequel le signal ( x ) de mesure est mélangé multiplicativement à la fréquence de modulation au signal ( r ) de référence déphasé de 90°, **caractérisé en ce qu'**est monté, en aval de l'autre détecteur ( 7 ) de phase, un dispositif ( 9 ) de commande qui détermine une grandeur ( u ) de commande correspondant à l'intensité du signal parasite à partir du signal ( x ) de mesure mélangé au signal ( r ) de référence déphasé de 90° et modifie par la grandeur ( u ) de commande, proportionnellement à celle-ci, la durée ( T ) d'intégration de l'intégrateur ( 6 ).

2. Amplificateur synchrone suivant la revendication 1, **caractérisé en ce que** le dispositif ( 9 ) de commande a des moyens ( 10, 11 ) pour élever au carré et ensuite intégrer le signal ( x ) de mesure mélangé au signal ( r ) de référence déphasé de 90°.

3. Procédé de filtrage d'un signal ( x ) de mesure, dans lequel des parties ( s ) de signal parasite, qui sont contenues dans le signal ( x ) de mesure modulé, sont éliminées par mélange multiplicatif du signal ( x ) de mesure à un signal ( r ) de référence à la fréquence de modulation et par intégration ensuite sur une durée ( T ) d'intégration prescrite et dans lequel, en outre, le signal ( x ) de mesure est mélangé multiplicativement à la fréquence de modulation au signal ( r ) de référence déphasé de 90°, **caractérisé en ce que** l'on détermine, à partir du signal ( x ) de mesure mélangé au signal ( r ) de référence déphasé de 90°, une grandeur ( u ) de commande correspondant à l'intensité du signal parasite, et **en ce que** l'on modifie par la grandeur ( u ) de commande, proportionnellement à celle-ci, la durée ( T ) d'intégration.

4. Procédé suivant la revendication 3, **caractérisé en ce que** l'on porte au carré le signal ( x ) de mesure mélangé au signal ( r ) de référence déphasé de 90°, pour déterminer la grandeur ( u ) de commande et ensuite on l'intègre.
